# EUROPÄISCHE PATENTSCHRIFT

(11) **EP 2 966 934 B1**
(45) Veröffentlichungstag und Bekanntmachung des Hinweises auf die Patenterteilung: **14.09.2016**
(21) Anmeldenummer: 14002346.6
(22) Anmeldetag: 08.07.2014
(51) Int. Cl.: H05B 3/42, F24H 3/04, F24H 9/18, H01L 23/495, H05K 3/20, H01L 23/34

(54) **Steuervorrichtung für eine elektrische Heizvorrichtung und Verfahren zu deren Herstellung**
Control device for an electric heating device and method for its production
Dispositif de commande pour un dispositif de chauffage électrique et son procédé de fabrication

(43) Veröffentlichungstag der Anmeldung: 13.01.2016
(73) Patentinhaber: Eberspächer catem GmbH & Co. KG, 76863 Herxheim (DE)
(72) Erfinder: Bohlender, Franz, 76870 Kandel (DE); Bilhöfer, Andreas, 67105 Schifferstadt (DE); Reger, Albert, 71120 Grafenau (DE); Schwarzer, Andreas, 60433 Frankfurt am Main (DE); Weber, Daniela, 67378 Zeiskam (DE)
(74) Vertreter: Grünecker Patent- und Rechtsanwälte PartG mbB

(56) Entgegenhaltungen:
- EP-A1- 0 590 644
- EP-A1- 2 043 412
- DE-A1- 19 604 614

## Beschreibung

Die vorliegende Erfindung betrifff eine Steuervorrichtung für eine elektrische Heizvorrichtung und ein Verfahren zu deren Herstellung.

Die vorliegende Erfindung betrifft insbesondere eine Steuervorrichtung für die Steuerung des Leistungsstromes einer elektrischen Heizvorrichtung eines kraftfahrzeugs mit den oberbegrifflichen Merkmalen von Anspruch 1. Eine solche Steuervorrichtung ist beispielsweise aus der EP 2 043 412 A1 bekannt. Diese Steuervorrichtung hat eine Leiterplatte, und eine von diesem Trägerelement gehaltene und daran befestigte Stromschiene, die elektrisch leitend mit einem SMD-Bauelement verbunden ist.

Bei dem SMD-Bauelement handelt es sich üblicherweise um einen Halbleiterleistungsschalter, der Verlustleistung erzeugt. Diese Verlustleistung muss regelmäßig abgeführt werden. So stellt die Stromschiene bei dem zuvor erwähnten Stand der Technik auch eine Wärmesenke dar, die mit einem separaten Kühlkörper verbunden ist, dessen Kühlrippen im Wesentlichen rechtwinklig von dem Trägerelement abragen. Das SMD-Bauelement ist auf einer Seite des Trägerelementes angeordnet; das Kühlelement auf der anderen.

Der Anmelderin sind eine Vielzahl von vorbekannten Lösungen bekannt, wie auch unter Berücksichtigung der notwendigen Abfuhr der Verlustwärme die Stromschiene ausgestaltet sein kann, um praktischen Anforderungen gerecht zu werden. Solche Lösungen sind beispielsweise aus der DE 10 2005 038 862 A1, JP 2001-319708, DE 195 18 522 A1, EP 1 395 098 A1, CN 2727957 Y, DE 199 35 803 A1, DE 10 2004 061 936 A1, EP 0 901 166 A1, US 6,442,033 B1 bekannt.

Die aus der EP 2 043 412 A1 vorbekannte Lösung ist wärmetechnisch ungünstig, da aufgrund der Anordnung des SMD-Bauelementes der Wärmeleitungsweg bis zu den Kühlrippen relativ weit ist. Darüber hinaus ist die Fertigung aufwändig und kostenintensiv. Schließlich ist die Lösung unbefriedigend, da die Leitung des Leistungsstromes nur über eine einzige Stromschiene erfolgt. Die Leiterplatte hat indes üblicherweise nur eine beschränkte Kapazität zum Durchleiten von hohen Leistungsströmen.

Insbesondere der letztgenannte Aspekt ist für Steuervorrichtungen zu elektrischen Heizvorrichtung bedeutsam, da dort relativ hohe Leistungsströme gesteuert bzw. geschaltet werden. Darüber hinaus will die vorliegende Erfindung insbesondere eine Steuervorrichtung für eine elektrische Heizvorrichtung in einem Kraftfahrzeug angeben. An solche elektrischen Heizvorrichtungen und deren Steuervorrichtung werden besondere Sicherheitsanforderungen gestellt. Die Einsatzbedingungen in einem Fahrzeug erfordern ferner eine sehr gute und solide Kontaktierung sämtlicher beteiligter Bauelemente. Vibrationen, Kälteunterschiede sowie gegebenenfalls feuchte und mit Verunreinigung behaftete Atmosphäre bedingen in besonderer Weise eine gute Kontaktierung und eine solide Durchleitung des Leistungsstromes. Übergangswiderstände im Leitungsweg des Leistungsstromes führen häufig zu lokalen Erwärmungen, die zum Durchlegieren des SMDBauelementes führen können. Ein thermisches Ereignis kann zum Durchschmoren der gesamten Steuervorrichtung, der gesamten Heizvorrichtung führen.

Die vorliegende Erfindung will eine Steuervorrichtung mit verbesserter elektrischer Leitungsbahn für den Leistungsstrom angeben. Diese Steuervorrichtung soll sich wirtschaftlich herstellen lassen und so will die vorliegende Erfindung auch ein entsprechendes Herstellungsverfahren angeben.

Zur Lösung des vorrichtungsmäßigen Problems wird mit der vorliegenden Erfindung eine Steuervorrichtung mit den Merkmalen von Anspruch 1 angegeben. Diese unterscheidet sich dadurch von dem zuvor erwähnten Stand der Technik, dass die Stromschiene Teil einer zunächst einteiligen stanzbearbeiteten Metallplatte ist. Die stanzbearbeitete Metallplatte hat zumindest einen durchtrennten Steg. Dieser durchtrennte Steg trennt die Metallplatte in ein Zuleitungselement und ein Ableitungselement. Das Zuleitungselement und das Ableitungselement sind elektrisch leitend mit dem und elektrisch allein durch das SMD-Bauelement verbunden. Das Zuleitungselement und das Ableitungselement sind aber ansonsten elektrisch voneinander isoliert vorgesehen und üblicherweise beide an dem Trägerelement befestigt, um einen vorbestimmten räumlichen Abstand der beiden Leitungselemente zu schaffen.

Soweit in der vorliegenden Erfindung auf die Zuleitung und die Ableitung abgestellt wird, geschieht dies lediglich zur terminologischen Unterscheidung der Elemente. Damit soll keine zwingende Festlegung erfolgen, in welcher Richtung der Strom relativ zu den jeweiligen Elementen und mit Blick auf das SMD-Bauelement fließen soll.

Der durchtrennte Steg ist an dem fertigen Erzeugnis mit seinen Trenn- bzw. Schneidkanten zu erkennen, die im Wesentlichen gegenüberliegend zu einzelnen Stromleitungselementen vorgesehen sind. Zwar ist es nach der vorliegenden Erfindung nicht erforderlich, die Stege erst nach dem Fügen der Metallpatte mit dem Trägerelement zu trennen. Bei einer solchen indes zu bevorzugenden Ausgestaltung sind zu jedem durchtrennten Steg üblicherweise Stanzöffnungen in dem Trägerelement vorgesehen, die den jeweiligen Stegen der einteiligen stanzbearbeiteten Metallplatte hinterlegt sind. So kann zum Zwecke einer angemessenen Darstellung zumindest für die bevorzugte Lösung der Erfindung auf solche Stanzöffnungen und nicht auf die durchtrennten Stege abgestellt werden.

Durch die erfindungsgemäße Lösung sind im Wesentlichen zwei Stromschienen geschaffen, nämlich zum einen das Zuleitungselement, auf welchem das SMD-Bauelement üblicherweise unmittelbar angeordnet und elektrisch mit diesem gebondet ist, sowie das Ableitungselement, welches elektrisch mit dem SMD-Bauelement verbunden ist, beispielsweise über zumindest einen seitlich an dem SMD-Bauelement abragenden Kontaktfuß. So wird der Leistungsstrom nicht nur unmittelbar durch das Zuleitungselement dem SMD-Bauelement zugeführt. Der Leistungsstrom wird auch über eine weitere und durch das Ableitungselement gebildete Stromschiene abgeführt.

Die beiden Stromschienen lassen sich wirtschaftlich herstellen, indem diese zunächst als Bereiche in einer einheitlichen stanzbearbeiteten Metallplatte ausgestanzt werden mit einem Steg, der beide Bereiche miteinander verbindet. Damit verbleiben die beiden Bereiche durch den zumindest einen Steg in vorbestimmter räumlicher Zuordnung zueinander. Sie befinden sich üblicherweise in einer Ebene. Ein Steg im Sinne der vorliegenden Erfindung hat eine wesentlich geringere Breite als die von diesem überragten Seitenflächen der Stromschiene. Dies ermöglicht die einfache Aufbringung des SMD-Bauelementes mittels SMD-Bestückungstechnik. Das SMD-Bauelement wird auf das Zuleitungselement üblicherweise aufgelötet. Auf das Ableitungselement wird der Kontaktfuß aufgelötet. Danach wird die einheitliche Ausgestaltung der Metallplatte aufgehoben, indem der bzw. die Stege durchtrennt werden. Damit werden aus der zunächst einheitlichen Metallplatte isoliert voneinander, d. h. beabstandet voneinander, vorgesehene Leitungsbahnen für den durch das SMD-Bauelement zu schaltenden Leistungsstrom geschaffen. Da sich der Kontaktfuß üblicherweise nicht gut für die mechanische Halterung des Ableitungselementes eignet, wird der Steg üblicherweise erst durchtrennt, nachdem das Zuleitungselement und das Ableitungselement mit dem Trägerelement verbunden worden sind. Das Verbinden mit dem Trägerelement kann auf unterschiedliche Weise erfolgen, beispielsweise durch Verkleben und/oder Verrasten.

Es versteht sich von selbst, dass das Trägerelement üblicherweise ein isolierend ausgebildetes Element ist, so dass das Aufbringen der beiden Leitungselemente zu keinem Kurzschluss zwischen diesen beiden Elementen führt. üblicherweise wird das Trägerelement aus Kunststoff ausgebildet und ist ein Spritzgussteil, üblicherweise aus einem thermisch hochwertigen Thermoplasten. Das Trägerelement ist üblicherweise keine Leiterplatte, die mit Bauelementen bestückt ist. Mit Blick auf eine möglichst kostengünstige Fertigung ist das Trägerelement allerdings lediglich eine spritzgegossene Kunststoffplatte.

Diese kann Rastnasen zum Verrasten von Zuleitungselement und Ableitungselement aufweisen. Ebenso gut kann dieses Trägerelement mit einem von einer Anlageebene für das Zuleitungselement und das Ableitungselement abragenden Zapfen versehen sein, welcher eine in dem Zuleitungs- bzw. Ableitungselement ausgesparte Bohrung durchragt. Die freien Enden dieser Zapfen können durch Warmverstemmen der endgültigen Befestigung des Zuleitungs- bzw. Ableitungselementes an dem Trägerelement dienen.

Bei der erfindungsgemäßen elektrischen Steuervorrichtung sind dementsprechend üblicherweise Zuleitungselement und Ableitungselement elektrisch isolierend an dem Trägerelement befestigt. Wie die obige Darstellung der Erfindung belegt, kann die Steuervorrichtung kostengünstig hergestellt werden. Sie bietet Stromschienen für die Zuleitung und die Ableitung des Leistungsstromes und damit eine verbesserte Durchleitung des Leistungsstromes durch die Steuervorrichtung. Die Stanzbearbeitung der Metallplatte mit nachfolgendem Durchtrennen des Steges ermöglicht eine einfache Herstellung der beiden Stromschienen. Wird der Steg erst nach der Montage des SMD-Bauelementes und dem Bonden auf beiden Stromschienen getrennt, so kann auf eine Positionierung der Stromschienen relativ zueinander für das Bonden verzichtet werden, da die räumliche Zuordnung von Zuleitungsbereich und Ableitungsbereich durch die Stege fest vorgegeben ist. Die erfindungsgemäße Steuervorrichtung hat üblicherweise keine herkömmliche Leiterplatte.

Gemäß einer bevorzugten Weiterbildung der vorliegenden Erfindung ist das SMD-Bauelement unmittelbar elektrisch mit dem Zuleitungselement gebondet, d. h. sitzt auf dem Zuleitungselement auf und ist damit verschraubt, insbesondere aber verlötet. Das Zuleitungselement ist darüber hinaus als Wärmesenke ausgebildet, d. h. befindet sich im Wärmeleitungsweg zwischen dem SMD-Bauelement als Wärmequelle und einer durch ein Fluid angeströmten Fläche für die Wärmeübertragung und -abfuhr der erzeugten Verlustleistung. Diese zur Wärmeübertragung vorgesehene Fläche wird vorzugsweise durch das Zuleitungselement selbst gebildet. So kann darauf verzichtet werden, ein gesondertes Kühlelement aufzubringen. Das Zuleitungselement bildet bei dieser bevorzugten Weiterbildung allein die zur Wärmeübertragung und -ableitung notwendige Fläche aus.

Durch Stanz- bzw. Stanz-Biegebearbeitung der Metallplatte kann die wirksame Oberfläche für die Abfuhr der Verlustleistung erhöht werden. So können durch Stanzen in der Ebene der Metallplatte sich erstreckende Kühlrippen ausgeformt werden. Diese Kühlrippen können auch durch Umbiegen aus der Ebene der Metallplatte herausgeführt werden. Dabei bleibt es üblicherweise bei der bevorzugten parallelen Ausrichtung von Zuleitungselement und Ableitungselement zueinander zur Anordnung auf einem bevorzugt ebenen Trägerelement. Das als Wärmesenke dienende Zuleitungselement kann das Trägerelement endseitig überragen und dort von dem Fluid angeströmt sein. Im Falle einer Steuervorrichtung für eine elektrische Heizvorrichtung in einem Kraftfahrzeug ist dieses Fluid üblicherweise Luft. Dabei wird insbesondere diejenige Luft zur Kühlung der Verlustleistung genutzt, welche durch die elektrische Heizvorrichtung erwärmt werden soll.

Dabei ist die Wärmesenke vorzugsweise so dimensioniert, dass das SMD-Bauelement bei langfristigem maximalem Stromdurchfluss und bei einer Anströmung der Wärmesenke mit Luft eine Temperatur von 150 °C nicht überschreitet. Die Anströmung mit Luft erfolgt dabei mit einem Luftstrom, der üblicherweise in einem HVAC eines Kraftfahrzeuges durch das darin vorgesehene Gebläse erzeugt wird. Die Luft hat eine Temperatur von nicht mehr als 80°C. Die Dimensionierung der Wärmesenke zur Wärmeabfuhr ist dabei unter den genannten Bedingungen vorzugsweise so, dass eine Verlustleistung des SMD-Bauelementes von zumindest 10 W, bevorzugt 11W, abgeführt werden kann. Eine solche Verlustleistung wird von den bevorzugt derzeit eingesetzten MOSFET's von Steuervorrichtungen in einer elektrischen Heizvorrichtung in einem Kraftfahrzeug erzeugt. Mit Blick auf ein denkbares Durchlegieren des MOSFET wird indes die Wärmesenke vorzugsweise so dimensioniert, dass eine Verlustleistung abgeführt werden kann, die um den Faktor 6 höher ist. Auch bei einem durchlegierten MOSFET, der eine Verlustleistung von etwa 60 bis 70 W abgibt, soll die Temperatur des Zuleitungselementes einen Wert von 320 °C nicht überschreitet.

Die Metallplatte ist dazu aus einem nicht nur elektrisch leitenden, sondern auch gut wärmeleitenden Werkstoff gebildet. Dabei kann es sich um Kupfer oder auch Messing oder Aluminium handeln. Bei Aluminium wird üblicherweise die Oberfläche galvanisch behandelt, um trotz der an Aluminium vorgesehenen Oxidschicht eine hinreichend gute elektrische Leitung zwischen der Aluminiummetallplatte und dem darauf aufgelöteten SMD-Bauelement zu erreichen. Zur angemessenen Ertüchtigung der Steuervorrichtung mit Blick auf die hier diskutierte Problematik einer Erwärmung, beispielsweise bei einem Durchlegieren des MOSFETs, wird das Trägerelement vorzugsweise aus einem thermisch hochwertigen Kunststoff hergestellt. Beispiele für solche Kunststoffe sind PPS (Polyphenylensulfid), insbesondere PPS GF 40, PEEK (Polyetheretherketon), insbesondere PEEK GF 30, PA (Polyamid) insbesondere PA6.6 GF.

Die erfindungsgemäße Steuervorrichtung ist mit dem Ziel gestaltet, auch bei einem Durchlegieren eines Leistungstransistors als SMD-Bauelement und im Falle maximaler Verlustleistung durch diesen Leistungstransistor und alle vorhandenen Leistungstransistoren einen thermischen Vorfall zu verhindern, bei welchem Teile der Steuervorrichtung durchschmelzen bzw. schmoren. Das bevorzugt das Trägerelement ausbildende thermoplastische Material ist geeignet, Temperaturen bis zu etwa 280°C, bevorzugt 320°C auszuhalten, ohne dass der Kunststoff schmort. Auf der Abstützungsseite des Trägerelementes, wo dieses üblicherweise an einer Außenwandung des Steuergehäuses abgestützt ist, und regelmäßig auf der dem SMD-Bauelement abgewandten Seite des Trägerelementes, sind üblicherweise Rippen und Stege vorgesehen, welche das Steuergehäuse von dem Trägerelement beabstanden, so dass keine erhebliche unmittelbare Wärmeleitung von dem hochwertigen Kunststoffmaterial des Trägerelementes auf das weniger hochwertige Kunststoffmaterial des Steuergehäuses erfolgen kann. Die hohe Wärmeleitfähigkeit der Metallplatte bewirkt, dass von dem SMD-Bauelement erzeugte Verlustleistung besonders effektiv in der Ebene der Metallplatte durch Wärmeleitung abgeführt und im Bereich der Wärmesenke durch Wärmeübertragung an das anströmende Fluid abgeführt wird. So kann die Stromschiene unterhalb des SMD-Bauelementes unmittelbar auf dem Trägerelement aufliegen, was im Hinblick auf eine solide Abstützung des SMD-Bauelementes zu bevorzugen ist. Es ist aber auch denkbar, selbst unter dem SMD-Bauelement in dem Trägerelement Aussparungen vorzusehen, so dass auch durch diese Maßnahme eine Kühlung, vor allem aber eine verringerte thermische Beaufschlagung des Kunststoffmaterials unmittelbar unterhalb des SMD-Bauelementes bewirkt wird.

Das Zuleitungselement bildet zur effektiven Kühlung von Verlustleistung des SMD-Bauelementes vorzugsweise unmittelbar benachbart zu dem SMD-Bauelement eine Kühlfahne aus. Diese Kühlfahne liegt in dem Fluidstrom frei. Hierzu hat das Trägerelement üblicherweise eine Fensteröffnung, in welchem das Zuleitungselement zumindest teilweise freiliegt. Das Zuleitungselement kann diese Fensteröffnung überragen, d. h. sich paral-lel zu dem Trägerelement über die Öffnung hinaus erstrecken und auf der gegenüberliegenden Seite ebenfalls an dem Trägerelement bevorzugt flächig abgestützt sein. Das Zuleitungselement kann aber ebenso gut im Bereich der Fensteröffnung abgewinkelt und zur Ausbildung einer relativ großen parallel von dem Luftstrom angeströmten Fläche sich rechtwinklig zu demjenigen Bereich des Zuleitungselementes erstrecken, auf dem SMD-Bauelement montiert ist. Eine solche Ausgestaltung bietet die Möglichkeit, das Trägerelement als Teil eines Gehäuses der elektrischen Heizvorrichtung auszubilden oder aber so zu dimensionieren, dass es sich in einem Steuergehäusebereich eines Gehäuses der elektrischen Heizvorrichtung zur soliden Abstützung der Stromschienen und darauf montierter Bauteile einbauen lässt. Kommt es auf diese Abstützung nicht an, kann die Kühlfahne auch über die Kontur des Trägerelementes hinausragen.

Gemäß einer weiteren bevorzugten Ausgestaltung der vorliegenden Erfindung weist das Trägerelement auf Höhe des durchtrennten Steges eine Stanzöffnung auf. Diese Stanzöffnung ist entweder von vornherein an dem Trägerelement ausgebildet oder Ergebnis der Stanzbearbeitung der Metallplatte und Ergebnis eines Vorgehens, bei dem Zuleitungs-elementbereich und Ableitungselementbereich zunächst verbunden durch den Steg auf dem Trägerelement befestigt und danach durch Stanzen oder anderweitiges Durchtrennen des Steges elektrisch voneinander getrennt werden. Hierbei wird auch das Trägerelement auf Höhe des Steges mit einer Öffnung versehen. Dabei kann die Stanzöffnung einheitlich mit der Fensteröffnung ausgebildet sein. In einer Projektion auf das Trägerelement ergibt sich dementsprechend ein Öffnungsbereich in dem Trägerelement, in den sich der durchtrennte Steg befindet, und ein weiterer Bereich, in den sich der als Wärmesenke ausgebildete Teil des Zuleitungselementes befindet, wobei beide Öffnungsbereiche von einer einheitlichen Kontur des Trägerelementes umgeben sind.

Vorzugsweise ist das Zuleitungselement zu beiden Seiten des SMD-Bauelementes als Wärmesenke ausgebildet. Dies bedeutet, dass die beiden von dem SMD-Bauelement abragenden Schenkel der Stromschiene der Wärmeabfuhr dienen und üblicherweise unmittelbar von einem Kühlfluid angeströmt werden, vorzugsweise Luft. Das freie Ende des Zuleitungselementes kann dabei das Trägerelement überragen. Der gegenüberliegende Schenkel, nachfolgend auch als zuleitungsseitiges Ende des Zuleitungselementes bezeichnet, liegt üblicherweise in einer Fensteröffnung des Trägerelementes frei und ist jenseits dieser Fensteröffnung zusätzlich durch das Trägerelement abgestützt. Dort ist das zuleitungsseitige Ende üblicherweise mit einem Anschluss für den zu schaltenden Leistungsstrom verbunden.

Gemäß einer bevorzugten Weiterbildung der vorliegenden Erfindung enthält die zunächst einteilig stanzbearbeitete Metallplatte ein mit einer Steuerstromzuleitung des SMD-Bauelementes verbundenes Steuerstromzuleitungselement. Dieses Streuerstromzuleitungselement ist über einen weiteren durchtrennten Steg von dem Zuleitungselement und/oder dem Ableitungselement beabstandet. Dementsprechend ergibt sich eine elektrische Trennung zwischen dem Steuerstromzuleitungselement und den Stromschienen für den Leistungsstrom. Das Steuerstromzuleitungselement liegt dabei bedingt durch die Herstellung der Stromschienen und des Steuerstromzuleitungselementes vorzugsweise in einer Ebene mit den Stromschienen. Mit Blick auf eine möglichst raumsparende Ausgestaltung befindet sich das Steuerstromzuleitungselement vorzugsweise benachbart zu dem zuleitungsseitigen Ende des Zuleitungselementes und zwischen dem Ableitungselement und einer Zuleitungsseite, wo das bzw. die Zuleitungselemente mit einer gemeinsamen Zuleitungsstromschiene elektrisch verbunden, vorzugsweise einteilig damit ausgebildet ist. Das Steuerstromzuleitungselement ist dabei quer zur Erstreckungsrichtung der Stromschienen üblicherweise wesentlich schmaler als die Stromschienen selbst ausgebildet. Es versteht sich, dass das Zuleitungs-, das Ableitungs- und das Steuerstromzuleitungselement in der Regel stoffidentisch ausgebildet sind.

Das Steuerstromzuleitungselement ist vorzugsweise ebenfalls mit dem Trägerelement verbunden ist, beispielsweise mit derjenigen Verbindungstechnik, mit welcher auch die das Zuleitungselement bzw. Ableitungselement ausbildenden Stromschienen mit dem Trägerelement verbunden sind.

Gemäß einer bevorzugten Weiterbildung der vorliegenden Erfindung überragt das Ableitungselement mit seinem freien Ende das Zuleitungselement und bildet mit seinem freien Ende eine Anschlussfahne zum Anschluss an einen Leistungsteil der elektrischen Heizvorrichtung aus. Diese Anschlussfahne kann einteilig mit einem Kontaktblech des Leistungsteiles ausgebildet sein. Sie kann durch Löten, Crimpen oder andere Verbindungsarten auch mit einem solchen Kontaktblech des Leistungsteiles verbunden werden, so dass zunächst die erfindungsgemäße Steuervorrichtung separat hergestellt und anschließend mit dem Leistungsteil elektrisch verbunden werden kann.

Gemäß einer bevorzugten Weiterbildung der vorliegenden Erfindung ist ein weiteres Stromschienenblech vorgesehen, das benachbart zu einer durch das Ableitungselement gebildeten Anschlussfahne eine Anschlussfahne anderer Polarität ausbildet. Sofern mehrere Ableitungselemente mit zugeordnetem SMD-Bauelement vorgesehen sind, befinden sich die durch die weitere Stromschiene gebildeten Anschlussfahnen anderer Polarität üblicherweise höhengleich und zwischen den Anschlussfahnen der Ableitungselemente. Damit wird ein kompakter elektrischer Anschluss an ein Leistungsteil einer PTC-Heizeinrichtung geschaffen, die nachstehend noch näher erläutert werden wird.

Die Erfindung betrifft ferner eine bestückte metallplasse einer solchen Steuervorrichtung nach Anspruch 13.

Mit der vorliegenden Erfindung wird ferner eine elektrische Heizvorrichtung für ein Kraftfahrzeug angegeben. Diese elektrische Heizvorrichtung hat in an sich bekannter Weise ein Leistungsteil, umfassend zumindest eine wärmeerzeugende Lage mit wenigstens einem PTC-Element und beidseitig daran anliegenden Kontaktblechen. Neben dieser wärmeerzeugenden Lage ist eine wärmeabgebende Lage vorgesehen. Die wärmeabgebende Lage liegt üblicherweise unmittelbar an der wärmeerzeugenden Lage an. Dabei kann die wärmeerzeugende Lage auch eine außenseitig das Kontaktblech abisolierende Isolierlage umfassen, so dass das wärmeerzeugende Element für sich isolierend in dem Leistungsteil vorgesehen ist und die wärmeabgebende Lage unbestromt ist, d. h. üblicherweise auf neutraler Polarität oder Masse liegt. Die elektrische Heizvorrichtung hat in an sich bekannter Weise ferner ein Steuerteil, welches in baulicher Einheit mit dem Leistungsteil vorgesehen ist. Eine solche elektrische Heizvorrichtung ist beispielsweise aus der EP 1 157 867 bekannt.

Erfindungsgemäß hat die vorbekannte elektrische Heizvorrichtung eine Steuervorrichtung gemäß einer der vorher diskutierten Ausgestaltungen. Diese Steuervorrichtung ist Bestandteil des Steuerteiles oder bildet das Steuerteil ausschließlich aus. Dabei ist eines der Kontaktbleche des Leistungsteils elektrisch leitend mit dem Ableitungselement verbunden, so dass der durch das SMD-Bauelement geschaltete Leistungsstrom auf den Leistungsteil übertragen wird. Das Steuerteil kann neben der zuvor diskutierten Steuervorrichtung weitere Elemente enthalten, beispielsweise eine mit elektrischen Bauteilen bestückte Leiterplatte. Vorzugsweise enthält das Steuerteil allerdings keine Leiterplatte im eigentlichen Sinne, d. h. ein Kunstharzgebilde mit darin eingearbeiteten Leitungsbahnen, auf welchen elektrische oder elektronische Bauteile montiert sind. Denn die erfindungsgemäße Steuervorrichtung lässt sich vorzugsweise ohne eine solche konventionelle Leiterplatte herstellen. Für das Schalten, Ansteuern und Durchleiten des Stromes müssen lediglich gestanzte und isolierend voneinander vorgesehene und durch das Trägerelement gehaltene Blechstücke ausgebildet sein; die nach Art einer Stromschiene ausgebildet sind und die für die Stromführung einer ersten Polarität allein über ein SMD-Bauelement elektrisch miteinander verbunden sind. Über diese Blechstücke, die ausgestanzt aus der zunächst einteilig ausgeformten Metallplatte hergestellt sind, erfolgt allein die Durchleitung des Leistungsstromes und des Steuerstroms.

Auf diese Weise kann die elektrische Heizvorrichtung einfach, kostengünstig und auch gewichtssparend hergestellt werden unter Beachtung der Maßgabe, dass hinreichend fähige Leiterbahnen mit angemessener Kapazität zur Durchleitung von hohen Leistungsströmen vorgesehen sind.

Gemäß einer bevorzugten Weiterbildung der vorliegenden Erfindung hat die elektrische Heizvorrichtung die zuvor erwähnte weitere Stromschiene, die eine Anschlussfahne anderer Polarität ausbildet. Diese Anschlussfahne anderer Polarität ist mit dem anderen Kontaktblech elektrisch leitend verbunden, so dass Stromzu- und -abfuhr zu dem Leistungsteil allein über die erfindungsgemäße Steuervorrichtung erfolgen kann. Die elektrische Heizvorrichtung lässt sich daher von einer Seite anschließen und dementsprechend einfach in ein HVAC durch Einschieben in dasselbe einbauen.

Gemäß einer bevorzugten Weiterbildung der vorliegenden Erfindung hat die elektrische Heizvorrichtung ein schalenförmiges Gehäuseelement, welches den Leistungsteil und den Steuerteil aufnimmt. Des Weiteren ist nach dieser Weiterbildung ein Gehäusegegenelement vorgesehen, welches unter Einschluss des Leistungsteiles und des Steuerteils das schalenförmige Gehäuseelement abdeckt. Dabei ist zumindest eines von Gehäuseelement und Gehäusegegenelement im Bereich der Anschlussfahnen mit zumindest einer Verbindungsöffnung versehen, um zwischen den Anschlussfahnen der Steuervorrichtung und dagegen anliegenden Verbindungsfahnen des Leistungsteils eine mechanische Verbindung auszuformen, nachdem das Gehäuse unter Einschluss von Steuerteil und Leistungsteil geschlossen worden ist. Gehäuseelement und Gehäusegegenelement haben üblicherweise zu jeder Wärmesenke bzw. Kühlfahne Gehäusefensteröffnungen, die ein Durchströmen des Fluids durch das Gehäuse und damit eine effektive konvektive Abfuhr der Verlustleistung erlauben. Die Gehäusefensteröffnungen können die Verbindungsöffnungen beinhalten. Durch eine geeignete mechanische Verbindung werden sowohl ein guter elektrischer wie auch ein soli-der mechanischer Kontakt zwischen den zu verbindenden Anschlussfahnen erzeugt. Diese Verbindung wird üblicherweise in einem Pressvorgang gebildet. Konkret können die Verbindungs- bzw. Anschlussfahnen miteinander durch Crimpen, Toxen oder Clinchen verbunden werden. Dabei ist die Verbindungsöffnung vorzugsweise so ausgebildet, dass sämtliche Kontaktfahnen zwischen dem Steuerteil und dem Leistungsteil durch einen einmaligen Hub des Presswerkzeuges miteinander verbunden werden können. Um Leistungsteil und Steuerteil bestmöglich in dem Gehäuse einzuschließen und zu schützen sowie abzudecken, wird vorzugsweise für jede zu verbindende Paarung von Anschlussfahnen eine zugeordnete Verbindungsöffnung ausgespart, in die ein Presswerkzeug eindringt, um die gewünschte mechanische Verbindung zwischen den Anschlussfahnen herzustellen. Regelmäßig ist der Fügebereich der Anschlussfahnen zwischen gegenüberliegenden Verbindungsöffnungen vorgesehen, die in dem Gehäuseelement und dem Gehäusegegenelement ausgespart sind. So ist auch hier ein Durchtritt von Luft durch das Gehäuse und eine Kühlung des Fügebereichs möglich.

Die vorliegende Erfindung bietet die Möglichkeit, das Trägerelement durch das Gehäuseelement bzw. das Gehäusegegenelement herzustellen. Auch ist die Möglichkeit gegeben, das Ableitungselement einteilig mit einer Verbindungsfahne des Leistungsteiles auszuformen. Bei dieser Verbindungsfahne kann es sich um das freie Ende eines unmittelbar an einem PTC-Element anliegenden Kontaktbleches handeln. Vorzugsweise ist die Verbindungsfahne gegenüber der durch das Kontaktblech gebildeten Anlagefläche zu dem PTC-Element um 90° umbogen, wodurch das Einlegen der Teile in das schalenförmige Gehäuseelement und das Verbinden der Verbindungsfahne mit dem Ableitungselement vereinfacht ist.

Mit Blick auf den verfahrensmäßigen Aspekt der vorliegenden Erfindung wird mit dieser ein Verfahren mit den Merkmalen von Anspruch 17 vorgeschlagen. Bei dem erfindungsgemäßen Verfahren zur Herstellung einer elektrischen Heizvorrichtung wird zunächst eine stanzbearbeitete Platte hergestellt, die im Wesentlichen der Kontur der Stromschienen der Steuervorrichtung entspricht. Es versteht sich von selbst, dass aus einer größeren Metallplatte mehrere solche Einheiten in einem Hub als Nutzen heraus gestanzt werden können. Die einer Polarität zugeordneten Stromschienen der Steuervorrichtung gegebenenfalls auch die Stromsteuerzuleitungselemente der Steuervorrichtung werden - verbunden durch Stege - zu einer Einheit durch Stanzen ausgeformt. Diese Stromschienen bzw. Leitungselemente sind Bereiche der Metallplatte. So hat die zunächst einteilige, stanzbearbeitete Metallplatte zumindest einen Zuleitungselementbereich und einen Ableitungselementbereich, gegebenenfalls auch einen Steuerstromzuleitungselementbereich. Diese Bereiche sind über einen, gegebenenfalls mehrere Stege miteinander verbunden. So kann die zunächst einteilige stanzbearbeitete Metallplatte gut als einheitliches Bauteil gehandhabt werden. In einem nachfolgenden Schritt wird auf dem Zuleitungselementbereich das SMD-Bauelement befestigt, üblicherweise aufgelötet, wodurch sich eine bestückte Metallplatteneinheit ergibt. Selbstverständlich können mehrere solche SMD-Bauelemente vorgesehen sein. Zusätzlich kann aber auch ein Stecker für den Steuerstrom beim Bestücken der Metallplatte mit dem SMD-Bauelement aufgebracht, insbesondere aufgelötet, werden. Weiterhin können elektrische Kontaktbrücken, die in der Regel aus elektrisch leitenden Stanz-Biege-Teilen gebildet sind, zwischen einzelnen Funktionsbereichen der Metallplatteneinheit aufgelötet sein. Solche elektrischen Kontaktbrücken werden insbesondere zwischen den Steuerstromzuleitungselementen bzw. -bereichen einer Steuervorrichtung zum Ansteuern von mehreren Heizkreisen ausgebildet. Jenseits dessen weist die bestückte Metallplatteneinheit in der Regel keine anderen bzw. weiteren elektronischen oder elektrischen Bauelemente auf.

Danach wird die bestückte Metallplatteneinheit an einem Trägerelement befestigt. Die Befestigung erfolgt dabei derart, dass die einzelnen Funktionsbereiche für sich jeweils mit dem Trägerelement verbunden sind. Dementsprechend ist jeder Zuleitungs-, Ableitungsund gegebenenfalls Steuerstromzuleitungsbereich jeweils für sich an dem Trägerelement befestigt. Diese Befestigung erfolgt vorzugsweise über Rastnasen, die an einem mittels Spritzgießen von Kunststoff hergestellten Trägerelement ausgebildet sind. Alternativ oder ergänzend können auch ein oder mehrere warmverstemmbare Zapfen Bohrungen in einzelnen oder sämtlichen Funktionsbereichen durchragen und mittels Warmverstemmen zu einer Befestigung von Funktionsbereich und Trägerelement führen oder beitragen. Beim Fügen von Metallplatteneinheit und Trägerelement oder danach werden bei dem erfindungsgemäßen Verfahren die einzelnen Funktionsbereiche elektrisch voneinander getrennt, indem die das Blechkontinuum zunächst sicherstellenden Stege durchtrennt werden. Dadurch wird ein Zuleitungselement und ein Ableitungselement erzeugt, die lediglich über das SMD-Bauelement elektrisch miteinander verbunden sind. Sofern ein Steuerstromzuleitungsbereich an der bestückten Metallplatteneinheit vorgesehen ist, wird der bzw. die Stege hierzu ebenfalls durchtrennt, um diesen Bereich zu einem Steuerstromzuleitungselement auszuformen, welches für sich und von den Zuleitungs- und Ableitungselementen elektrisch isoliert an dem Trägerteil gehalten und nur über das SMD-Bauelement elektrisch mit diesen Elementen verbunden ist. Mit Blick auf eine Massenherstellung wird ferner die Übung bevorzugt, den Nutzen mit seinen jeweiligen Metallplatteneinheiten in den zugeordneten Trägerelemente anzuordnen und damit zu befestigen und dabei gleichzeitig die jeweiligen Metallplatteneinheiten aus dem Nutzen zu trennen. So werden in Einem mehrere erfindungsgemäße Steuervorrichtungen hergestellt und aus dem Nutzen vereinzelt. Dieser Schritt wird üblicherweise durch eine kombinierte Montageund Trennvorrichtung erreicht, welche die Metallplatteneinheit relativ zu dem Trägerelement positioniert hält und beide Teile so aufeinander zu bewegt, dass diese miteinander verbunden werden und die einzelnen Leitungselemente der Metallplatteneinheit durch Trennen von Stegen voneinander getrennt werden.

Auf diese Weise wird mit hoher Genauigkeit die Lage der einzelnen Leitungselemente an dem Trägerteil vorbestimmt und festgelegt. Die Montage ist einfach, da die einzelnen Elemente zunächst im Kontinuum gehandhabt und als solche auf das Trägerelement übertragen und damit befestigt werden. Erst danach wird durch Trennen des bzw. der Stege eine elektrische Trennung zwischen den einzelnen Bereichen geschaffen, um die elektrisch isoliert an dem Trägerelement vorgesehenen Funktionsteile zu bilden.

Weitere Merkmale, Vorteile und Einzelheiten der vorliegenden Erfindung ergeben sich aus der nachfolgenden Beschreibung eines Ausführungsbeispiels in Verbindung mit der Zeichnung:

In dieser zeigen:
- Fig. 1: eine perspektivische Draufsicht auf die Unterseite der Leitungsbahnen des Ausführungsbeispiels;
- Fig. 1a: das Detail D gemäß Fig. 1 in vergrößerter Darstellung in einer Draufsicht;
- Fig. 2: eine perspektivische Explosionsdarstellung mit einer perspektivischen Draufsicht auf eine bestückte Metallplatteneinheit in etwa entsprechend dem in Fig. 1 gezeigten Ausführungsbeispiel und einem Ausführungsbeispiel eines Trägerelementes;
- Fig. 3: eine perspektivische Draufsicht auf die in Fig. 2 gezeigten Elemente nach dem Fügen und vor dem Freistanzen;
- Fig. 4: eine perspektivische Draufsicht auf die in Fig. 2 gezeigten Elemente nach dem Fügen und nach dem Freistanzen;
- Fig. 5: eine perspektivische unterseitige Ansicht des in den Fig. 2 und 3 gezeigten Ausführungsbeispiels;
- Fig. 6: eine vergrößerte perspektivische Schnittdarstellung entlang der Linie VI-VI gemäß der Darstellung in Fig. 3;
- Fig. 7: eine perspektivische Draufsicht auf ein mit der Steuervorrichtung nach den Fig. 1 bis 6 bestücktes Gehäuse einer elektrischen Heizvorrichtung;
- Fig. 8: das Ausführungsbeispiel nach Fig. 7 nach dem Einbringen eines Leistungsteiles in das Gehäuseteil;
- Fig. 9: das in Fig. 8 gezeigte Ausführungsbeispiel bei geschlossenem Gehäuse und
- Fig. 10: eine perspektivische Längsschnittansicht entlang der Linie X-X gemäß der Darstellung in Fig. 9.

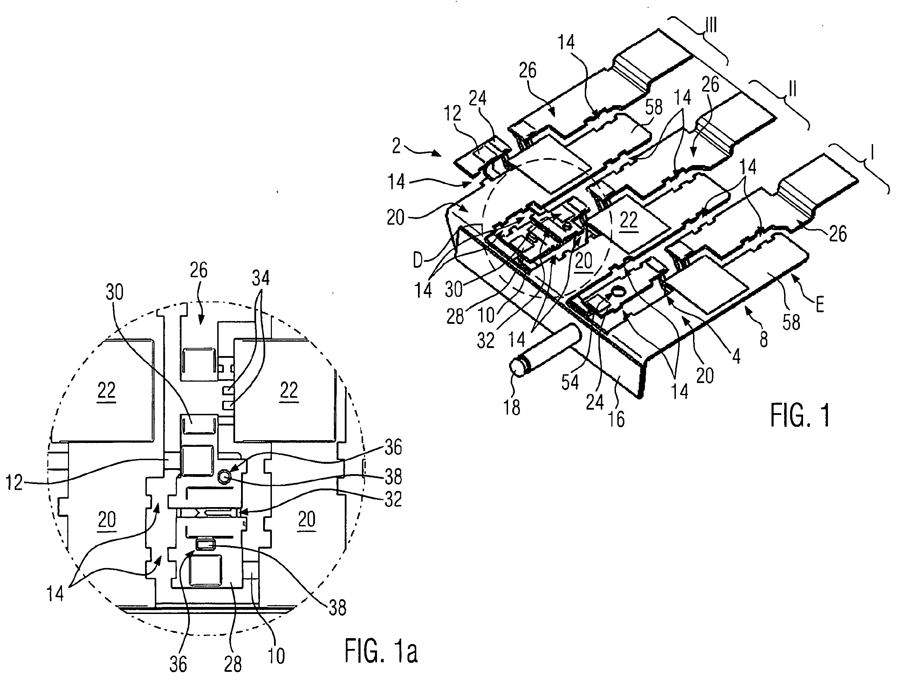

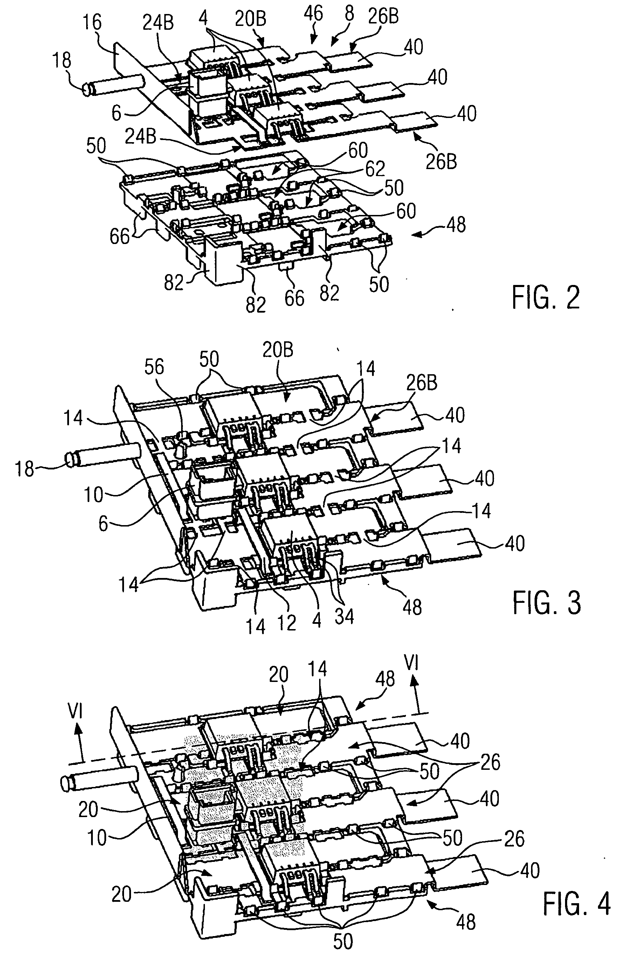

Die Figur zeigt im Wesentlichen Leitungsbahnen einer Steuervorrichtung als Ausführungsbeispiel der vorliegenden Erfindung. Verständlich wird die Gestaltung insbesondere in Verbindung mit den Fig. 2 und 3. So zeigen die Fig. 2 und 3 eine bestückte Metallplatteneinheit 2, die durch Stanz- und Biegebearbeitung aus einer Metallplatte 8 bzw. einem Metallblech hergestellt ist. Bestückt ist die Metallplatte durch drei SMD-Bauelemente 4, bei denen es sich vorliegend um Leistungstransistoren (MOSFET) handelt, sowie ein Steckergehäuse 6. Die SMD-Bauelemente 4 und die Steckergehäuse 6 sind zur Ausbildung der bestückten Metallplatteneinheit 2 mit einer Metallplatte 8 durch Löten zu verbinden. Des Weiteren sind mit Bezugszeichen 10 und 12 gekennzeichnete elektrische Kontaktbrücken vorgesehen, die verschiedene in Breitenrichtung nebeneinanderliegende ausgestanzte Flächenbereiche miteinander verbinden. Bei der in Fig. 3 gezeigten bestückten Metallplatteneinheit sind verschiedene, nachstehend noch näher diskutierte Bereiche der Metallplatte 8 über Stege 14 miteinander verbunden. In Fig. 1 sind Bezugszeichen 14 auf diejenigen Stellen gerichtet, in denen zuvor Stege 14 der bestückten Metallplatteneinheit 2 vorgesehen waren.

Wie aus den Fig. 2 und 3 ersichtlich, ist die Metallplatte 8 durch Stanz- und Biegebearbeitung hergestellt. Es ist ein Stanzgitter aus im Wesentlichen sechs parallel zueinander vorgesehenen stegförmigen Ausgestaltungen ausgebildet. An dem hinteren, zuleitungsseitigen Ende der Metallplatte 8 ist eine Zuleitungsstromschiene 16 durch einfaches Falten und Gegeneinanderlegen der Blechlage der Metallplatte 8 ausgeformt, von der ein daran unmittelbar befestigter, beispielsweise angelöteter Anschlusszapfen 18 abragt. Vorliegend erstreckt sich die Zuleitungsstromschiene 16 rechtwinklig zu der Haupterstreckungsrichtung der Metallplatte 8, so dass sich der Anschlusszapfen 18 parallel zu der Metallplatte 8 erstreckt. Eine solche Ausgestaltung ist aber nicht erforderlich zur Verwirklichung der Erfindung. Der Zapfen 18 kann sich in jeder beliebigen Richtung erstrecken. Der Anschlusszapfen 18 gibt dabei üblicherweise die Ansteckrichtung zum elektrischen Anschluss des Leistungsstromes vor. Durch Stanz- und Biegebearbeitung kann die Zuleitungsstromschiene 16 und damit der Anschlusszapfen 18 jede beliebige Ausrichtung haben.

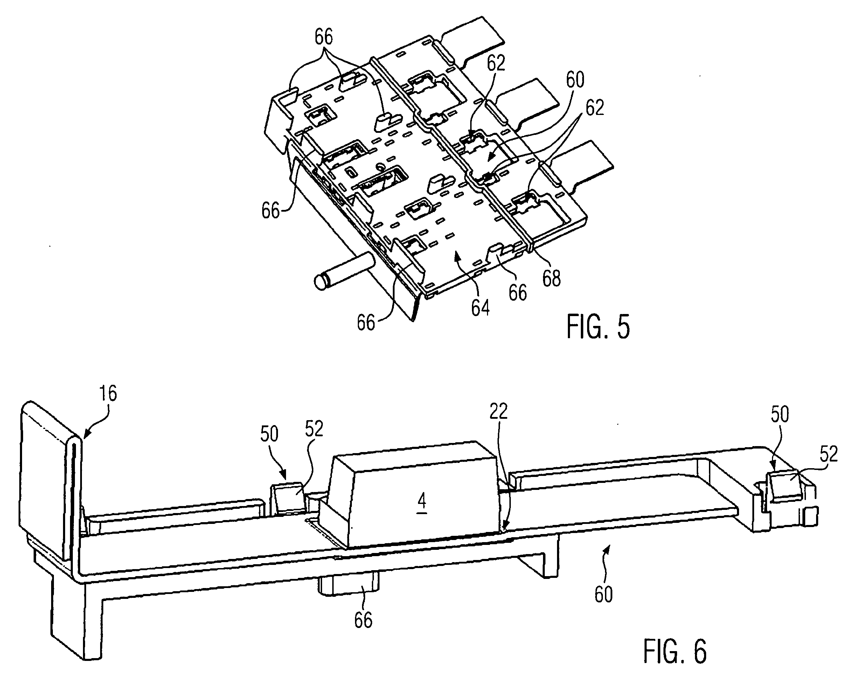

In einer im Folgenden als Stromleitungsebene E bezeichneten Ebene befinden sich unmittelbar mit der Zuleitungsstromschiene 16 verbundene Zuleitungselemente 20. Diese Zuleitungselemente 20 bilden jeweils für sich eine SMD-Haltebasis 22 aus, die - wie Fig. 6 verdeutlicht - durch Stanzbearbeitung gegenüber der Stromleitungsebene E leicht abgesenkt ausgebildet ist, so dass beim Auflöten des SMD-Bauelementes 4 Lot an vorbestimmter Stelle verbessert gehalten werden kann. Die SMD-Haltebasis 22 ragt seitlich von dem im Grunde stegförmigen Zuleitungselement 20 ab. Zwischen benachbarten Zuleitungselementen bzw. seitlich neben einem solchen ist nahe der Zuleitungsseite zumindest ein Steuerstromzuleitungselement 24 vorgesehen. In Verlängerung des Steuerstromzuleitungselementes 24 befindet sich ein Ableitungselement 26. Zu jedem Heizkreis I-III ist ein einziges Ableitungselement 26 und ein einziges Zuleitungselement 20 vorgesehen. Des Weiteren ist zu jedem Heizkreis zumindest ein Steuerstromzuleitungselement 24 vorgesehen. Das Steckergehäuse 6 sitzt auf zwei durch Stanzen bereits von vorneherein voneinander getrennten Steuerstromzuleitungselementen 28, 30 auf. Diese sind durch einen Schlitz 32 voneinander getrennt, indes durch verschiedene Stege 14 lagestabilisiert an der gestanzten einheitlichen Metallplatte 8 gehalten (s. Figur 1 a).

Wie die unterseitige perspektivische Ansicht nach Fig. 1 verdeutlicht, sind an jeder Lötstelle auch für die elektrischen Kontaktbrücken 10, 12 sowie für Kontaktfüße 34 des SMDBauelementes 4 die Kontaktstellen an der Metallplatte 8 durch Einsenken vertieft, um das Lot an vorbestimmter Stelle zu halten. Entsprechendes gilt für Kontaktelemente, die durch das Steckergehäuse 6 gehalten sind und die mit den beiden Steuerstromzuleitungselementen 28, 30 gebondet sind. Diese Steuerstromzuleitungselemente 28, 30 weisen ferner Halteöffnungen 36 zur Aufnahme von von dem Steckergehäuse 6 unterseitig abragenden Befestigungszapfen 38 auf.

Fig. 1 verdeutlicht, dass das Ableitungselement 26 und das Zuleitungselement 20 jeweils als Stromschiene durch Stanzen und gegebenenfalls Biegen der Metallplatte 8 ausgebildet und parallel zueinander ausgerichtet sind. Die Ableitungselemente 26 überragen in Längsrichtung der jeweiligen Stromschienen die zugehörigen Zuleitungselemente 20, enden höhengleich und sind an ihrem freien Ende zur Ausformung einer außerhalb aber parallel zu der Ebenen E liegenden Anschlussfahne 40 gekröpft. Diese Ausgestaltung erfolgt mit dem Ziel, die Anschlussfahnen 40 auf den Boden eines nachstehend noch zu beschreibenden Gehäuses 42 eines elektrischen Kfz-Zuheizers 44 anzulegen.

Mit Blick auf eine möglichst kompakte Ausgestaltung in Breitenrichtung hat das Ableitungselement 26 auf Höhe des SMD-Bauelementes 4, d.h. der SMD-Haltebasis 22 einen Einschnitt 45, der in etwa den konstanten schlitzartigen Zwischenraum zwischen dem Zuleitungselement 20 und dem Ableitungselement 26 fortsetzt. Das Ableitungselement 26 endet ferner anschlussseitig in etwa auf Höhe der SMD-Haltebasis 22. Das zugeordnete Steuerzuleitungselement 24 endet ebenfalls mit seinem vorderen Ende auf Höhe des SMD-Bauelementes 4 und erstreckt sich in Verlängerung des Ableitungselementes 26, jedoch mit Abstand dazu.

Wie ersichtlich sind entsprechend den drei Heizkreisen I bis III drei Unterbaugruppen mit jeweils einem Zuleitungselement 20, einem Ableitungselement 26, einem Steuerstromzuleitungselement 24 und einem SMD-Bauelement 4 vorgesehen, wobei die das Zuleitungselement 20 und das Ableitungselement 26 einer Unterbaugruppe jeweils elektrisch miteinander verbindenden SMD-Bauelemente 4 nebeneinander, d.h. in Querrichtung hintereinander angeordnete sind. Sämtliche Zuleitungselemente 20 der Unterbaugruppen sind elektrisch miteinander über die Zuleitungsstromschiene 16 verbunden.

Die Fig. 2 und 3 verdeutlichen die zunächst einteilige Ausgestaltung der stanzbearbeiteten Metallplatte 8. Diese weist von Stegen 14 beabstandet und über diese verbundene Bereiche auf, die mit Bezugszeichen B gekennzeichnet sind, welches dem Bezugszeichen der zuvor bereits erwähnten einzelnen Stromleitungsteile nachgestellt ist um zu kennzeichnen, dass es hierbei um die noch miteinander verbundenen Bereiche zur Ausbildung der jeweiligen Funktionsteile handelt. Die zunächst einheitliche Metallplatte 8 wird durch Stanzen und Biegen in die aus den Fig. 2 und 3 ersichtliche Form gebracht. Danach werden sämtliche Lötvorgänge durchgeführt, um die SMD-Bauelemente 4, das Steckergehäuse 6 mit seinen jeweiligen Kontaktelementen und auch die elektrischen Kontaktbrücken 10, 12, die die Steuersignale von den Elementen 28 bzw. 30 auf die Steuerstromzuleitungselmente 24 übertragen, mit der Metallplatte 8 zu verbinden. Bei dem gezeigten Ausführungsbeispiel sind weitere Lötvorgänge nicht erforderlich. Die zuvor beschriebenen, auf die Metallplatte 8 aufgebrachten weiteren Bauteile stellen sämtliche Bauteile der Steuervorrichtung dar. Es fehlt insbesondere eine herkömmliche bestückte Leiterplatte. Voneinander getrennte Elemente der zunächst einheitlichen Metallplatte 8 bilden ausschließlich die Leitungsbahnen für den Leitungsstrom und den Steuerstrom aus.

Die in dieser Weise vorbereitete bestückte Metallplatteneinheit 2 wird auf ein Trägerelement 48 aufgesetzt und mit diesem verbunden. Hierzu weist das Trägerelement 48 eine Velzahl von Rastnasen 50 mit zugeordneten Gleitflächen 52 auf (vgl. Fig. 6), die beim Aufbringen der bestückten Metallplatteneinheit 46 elastisch nach außen gedrängt werden und sich selbstständig mit ihren Verriegelungsflächen 50 über die Oberfläche der einzelnen stromleitenden Plattensegmente 20B, 24B, 26B, 28B, 30B legen, um diese zu fixieren. Wie aus Fig. 1 ersichtlich, weist das zwischen zwei Zuleitungselementen 20 vorgesehene Steuerstromzuleitungselement 24 eine Bohrung 54 auf, die von einem der Zentrierung und der Halterung dienenden konischen Zapfen 56 durchragt wird.

Die Ausgestaltung von Bohrung 54 und Zapfen 56 stellt ferner sicher, dass das Trägerelement 48 nur in vorbestimmter Weise mit der bestückten Metallplatteneinheit 46 gefügt werden kann und sichert die exakte Positionierung insbesondere in Längenrichtung der einzelnen Stromschienen.

Nach dem Fügen von Trägerelement 48 und bestückter Metallplatteneinheit 46 werden sämtliche Stege 14 durchtrennt, um die bereits unter Bezugnahme auf Fig. 1 beschriebenen Leitungselemente zu isolieren. Danach ist das Zuleitungselement 20 eines Heizkreises I; II; III mit dem zugeordneten Ableitungselement 26 lediglich über das SMD-Bauelement 4 elektrisch verbunden. Diese elektrische Verbindung erfolgt über die dem Leitungsstrom durchleitenden Kontaktfüße 34 des SMD-Bauelementes, die auf dem zugeordneten Ableitungselemente 26 aufgelötet sind. Ein weiterer Kontaktfuß 34 für den Steuerstrom verbindet das SMD-Bauelement 4 eines jeden Heizkreises I; II; III elektrisch mit dem zugehörigen Steuerstromzuleitungselement 24 bzw. 30. Jedes einzelne der zur Steuerstrom- und Leistungsstromleitung vorgesehenen Elemente ist für sich durch die Rastnasen 50 bzw. den Zapfen 56 an dem Trägerelement 48 hinreichend fixiert und lagepositioniert gehalten. Das Trägerelement 48 ist so ausgebildet, dass die Zuleitungselemente 20 mit ihrem freien, eine Kühlfahne 58 als Wärmesenke ausbildenden Ende innerhalb der Kontur der Trägerelementes 48 vorgesehen sind. Lediglich die Ableitungselemente 26 überragen mit ihrer Anschlussfahne 40 das Trägerelement 48.

Die Kühlfahne 58 befindet sich in einer Kühlfensteröffnung 60, die in dem Trägerelement 48 ausgespart ist. Zu jeder einzelnen Kühlfahne 58 ist eine entsprechende Kühlfensteröffnung 60 vorgesehen. Diese Kühlfensteröffnung 60 ist jeweils einheitlich mit zwei Stanzöffnungen 62 ausgeformt, die Stege 14 unterlegen, welche jeweils Zuleitungselemente 20 und Ableitungselemente 26 im vorderen Bereich der Zuleitungselemente 20 miteinander verbinden (vgl. Fig. 3). Die entsprechenden Stanzöffnungen 62 sind in Fig. 5 eingezeichnet. Weitere Stanzöffnungen 62 sind nahe der Zuleitungsseite an dem Trägerelement 48 ausgeformt, um dort befindliche Stege 14 zu trennen. Zu jedem der Stege 14 ist eine Stanzöffnung 62 zum nachträglichen Durchtrennen der Stege 14 ausgeformt. Mitunter sind größere Stanzöffnungen 62 vorgesehen, durch welche mehrere Stege 14 gemeinsam erreicht und durchtrennt werden können. Beim Durchtrennen der Stege 14 greift ein Stanzwerkzeug einerseits in die Stanzöffnungen 62 von unten ein und wirkt von oben gegen den Steg, um diesen auszustanzen bzw. abzuscheren. Wenngleich das Stanzen die bevorzugte Art der Trennung der Stege 14 darstellt, können diese auch mit beliebigen anderen Verfahren durchtrennt werden, wie beispielsweise dem Laserschneiden oder dem Sägen. Das Stanzen erlaubt indessen ein Entfernen sämtlicher Stege 14 mit einem Hub eines an die Anordnung der Stege angepassten Stanzstempels und ist somit besonders wirtschaftlich. Ferner kann der Hub für das Stanzen auch genutzt werden, um zunächst die Metallplatteneinheit in Einem mit dem Trägerelement 48 zu fügen.

Nachstehend werden einige Details des Trägerelementes 48 näher erläutert. Bei dem gezeigten Ausführungsbeispiel ist das Trägerelement 48 als spritzgegossenes Bauteil hergestellt. Spritzgegossen wird ein thermisch hochwertiger Thermoplast, wie beispielsweise PA66 bzw. PPS. Wie die rückseitige Draufsicht gemäß Fig. 5 verdeutlicht, wird eine im Grunde plattenförmige Basis 64 des Trägerelementes 48 rückseitig von mehreren Abstandsstegen 66 überragt, die der eher punktuellen Abstützung des Trägerelementes 48 gegen das Gehäuse 42 des Kfz-Zuheizers 44 dienen. Hiermit wird eine gewisse thermische Entkopplung zwischen dem thermisch hochwertig ausgebildeten Trägerelement 68 und dem Gehäuse 42 geschaffen. In Querrichtung ragt von der Basis 46 rückseitig durchgehend ein Trennsteg 48 ab, welcher den Bereich mit den Kühlfensteröffnungen 66 von dem anschlussseitigen Bereich des Trägerelementes 48 abteilt. Damit wird verhindert, dass die zur Kühlung einströmende Luft an der Anströmseite hinter die SMD-Bauelemente 4 gelangt. Die Anströmung erfolgt vorliegend von der in Fig. 5 gezeigten Unterseite des Trägerelementes 48. Wie ferner verdeutlicht, sind die SMD-Bauelemente 4 bei dem gezeigten Ausführungsbeispiel vollflächig von Material des Trägerelementes 48 abgedeckt, so dass selbst bei einer denkbaren Leckage von Luft diese nicht unmittelbar die sensiblen SMD-Bauelemente 4 erreichen kann.

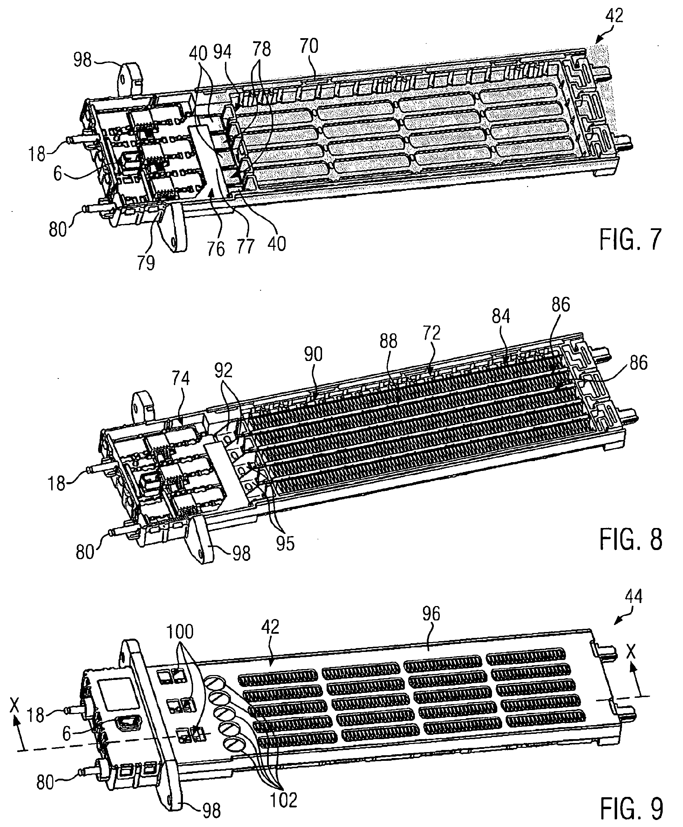

Die Fig. 7 zeigt ein Einbau des zuvor beschriebenen Ausführungsbeispiels der Steuervorrichtung in ein schalenförmig ausgebildetes Gehäuseelement 70 des elektrischen Kfz-Zuheizers 44, der als reiner elektrischer Heizer ausgebildet ist und keine wasserführenden Rohre hat. Das Gehäuseelement 70 hat einen Aufnahmebereich für einen Leistungsteil 72 und einen ein Steuergehäuse ausbildenden Aufnahmebereich für einen Steuerteil 74. Neben der zuvor beschriebenen Leiterbahn für die Leitung des Leistungsstromes enthält der Steuerteil 74 eine durch Stanzen und Biegen hergestellte Stromschiene 76 anderer Polarität, die zwischen den Anschlussfahnen 40 der Ableitungselemente 46 zwei Anschlussfahnen 78 der anderen Polarität ausbildet. Diese Anschlussfahnen 78 anderer Polarität sind parallel zu den Anschlussfahnen 40 vorgesehen und liegen, wie die Anschlussfahnen 40, auf der Innenseite gegen eine Innenfläche des Gehäuseteils 70 an. Die Anschlussfahnen 78 anderer Polarität werden über ein sich in Breitenrichtung erstreckendes Stromschienensegment 77 seitlich zu einem innen gegen eine Seitenwand des Gehäuseteils 70 angelegten Stromschienenstrang 79 verlängert, der stirnseitig umbogen ist, dort sich parallel zu der stirnseitigen Gehäusewand des Gehäuseteils 70 erstreckt und mit einem Anschlusszapfen 80 anderer Polarität versehen ist. Von dem Trägerelement 48 abragende Stützstege 82 (vgl. Figur 2) halten den Stromschienenstrang 79 der Stromschiene 76 in Position und auf Abstand zu sämtlichen Stromschienen 20, 26 der ersten Polarität.

Wie Fig. 8 verdeutlicht, wird der Leistungsteil 72 gebildet durch Wellrippenelemente 84, die als wärmeabgebende Lagen des Leistungsteils 72 vorgesehen sind. Zwischen diesen Wellrippen 84 sind wärmeerzeugende Lagen 86 angeordnet. Die wärmeerzeugenden Lagen 86 und die Wellrippen 64 bilden einen Heizblock 88 aus, dessen Lagen über ein Federelement 90 gegeneinander angelegt werden. Die wärmeerzeugenden Lagen 86 umfassen PTC-Elemente 91, die zwischen Kontaktblechen 92 und in einem an die PCT-Elemente 91 angepasste Aufnahmen aufweisenden Positionsrahmen 93 aus einem isolierenden Material zur Positionierung der PTC-Elemente 91 aufgenommen sind. Einzelne Kontaktbleche 92 der wärmeerzeugenden Lagen 86 sind über den Heizblock 88 seitlich hinaus verlängert und in Schlitzen einer Trennwand 94 gehalten, die durch das Gehäuseunterteil 70 zwischen dem Leistungsteil 72 und dem Steuerteil 74 ausgeformt sind. Diese über die Trennwand 94 hinausgeführten Enden der Kontaktbleche 92 bilden durch Biegen parallel zu den Anschlussfahnen 40 der ersten Polarität und den Anschlussfahnen 80 der anderen Polarität ausgerichtete Verbindungsfahnen 95 aus, die auf die Anschlussfahnen 40, 80 aufgelegt sind.

Das in dieser Weise bestückte Gehäuseunterteil 70 wird mit einer Bezugszeichen 96 gekennzeichneten Gehäuseabdeckung 96 unter Einschluss von Leistungsteil 72 und Steuerteil 74 abgedeckt.

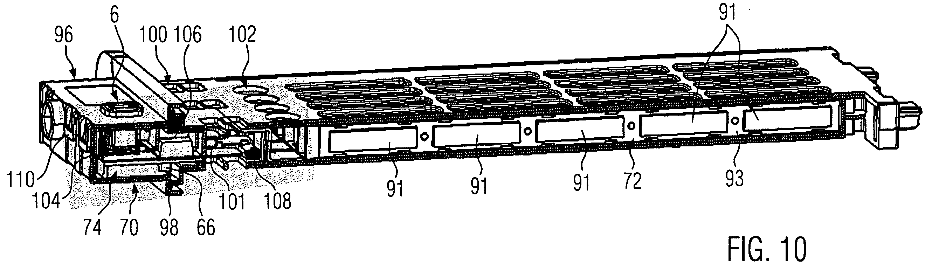

Wie Fig. 9 verdeutlicht, hat diese Gehäuseabdeckung 96 eine Aussparung, die von dem Steckergehäuse 6 durchragt ist und die in dem Steckergehäuse 6 vorgesehenen elektrischen Anschlusselemente freilässt. Die Anschlusszapfen 18, 80 überragen das durch die beiden Gehäuseelemente 70, 96 gebildete Gehäuse 42, welches vorliegend zweiteilig ausgebildet ist und einen Flansch 98 zur Befestigung des Kfz-Zuheizers 44 an einem HVAC-Weg ausformt. Auf der der Anschlussseite gegenüberliegenden Seite unmittelbar benachbart zu dem Flansch 98 sind in der Gehäuseabdeckung 96 und korrespondierend dazu (nicht gezeigt) an dem Gehäuseschalenelement 70 Kühlfenster 100 vorgesehen, die korrespondierend zu der Lage der Kühlfahnen 58 und der Kühlfensteröffnungen 60 des Trägerelementes 48 ausgespart sind und einen Durchtritt von Luft durch das Gehäuse 42 erlauben. Die Gehäuseabdeckung 96 weist einen benachbart zu den Kühlfenstern 100 angeordneten und in Richtung auf das Gehäuselement 70 innenseitig abragenden Steg 101 auf, der bis zu dem Trägerelement 48 und den dortigen Stromschienen reicht und auch auf dieser Seite verhindert, dass die durch die Kühlfenster 100 durchtretende Luft.zu den SMD-Bauelemente gelangt. Wie insbesondere Figur 10 verdeutlicht, ist das Leistungsteil 72 und das Steuerteil 74 somit vollständig in einem zweiteiligen Gehäuse eingeschlossen, wobei Gehäuseelemente dafür sorgen, dass das Steuerteil 74 zumindest teilweise eingehaust ist und nicht mit der zu erwärmenden Luft in Berührung kommt. Die SMD-Bauelemente 4 liegen danach abgeschlossen in dem Gehäuse 40, 96 im Wesentlichen eingesiegelt, wohingegen die Kühlfahnen 58 und die Anschlussfahnen 40, 78 dem zu erwärmenden Luftstrom ausgesetzt sind.

Zwischen dem Leistungsteil und den Kühlfenstern 100 sind fünf in einer Reihe nebeneinanderliegende Verbindungsöffnungen 102 gezeigt, die in Verlängerung der jeweiligen Anschlussfahnen 40, 80 vorgesehen sind. Korrespondierende Verbindungsöffnungen 100 sind an dem anderen Gehäuseteil 70 ausgespart. Diese Verbindungsöffnungen 102 dienen dem Eingriff eines Umformwerkzeuges, mit dem die aufeinanderliegenden Verbindungsfahnen 95 des Leistungsteils und die entsprechenden Anschlussfahnen 40 bzw. 80 des Steuerteils 74 miteinander verbunden werden können. Die Verbindung ist eine Clinchverbindung. Das Verstemmen oder Toxen erfolgt üblicherweise in einem Hub um sämtliche Verbindungsfahnen 95 mit den zugeordneten Anschlussfahnen 40, 80 zu verbinden. Die Verbindungsöffnungen 102 ermöglichen ferner einen Durchtritt von Luft und damit eine Kühlung an der Phasengrenze zwischen Steuerteil 74 und Leistungsteil 72.

Die Figur 10 lässt weitere Details der Gehäuseabdeckung 96 erkennen. Diese hat unmittelbar benachbart zu der Zuleitungsstromschiene 16 einen ersten Steg 104, der von der Innenseite der Gehäuseabdeckung 96 abragt und zwischen der Außenwandung des Gehäuseunterteils 70 einen Aufnahmeraum für die Positionierung und Halterung der Zuleitungsstromschiene 16 ausbildet. Beiderseits des SMS-Bauelementes 4 sind zweite und dritte Stege 106, 108 vorgesehen, die auch als Niederhalter für Elemente des Steuerteils 74 dienen können. Der zweite Steg 106 schafft ferner eine aus Kunststoff geformte Isolation zwischen der elektrischen Kontaktbrücke 12 und dem SMB-Bauelement 4 und verlängert dementsprechend die Luftstrecke zwischen den beiden Elementen. Die innerre Profilierung der Gehäuseabdeckung 96 dient dementsprechend mehreren Zwecken. So wird die Kriech- und/oder Luftstrecke innerhalb des Steuerteils 74 vergrößert. Auch werden durch die einteilig an der Gehäuseabdeckung 96 ausgebildeten Stege 101, 104, 106, 108 Gefache und/oder Niederhalter bzw. Positionierhilfen für die einzelnen Elemente des Steuerteils 74 geschaffen. So wird durch Schließen des Gehäuses auch das Steuerteil 74 in einer die sichere Funktion der elektrischen Heizvorrichtung begünstigenden Weise montiert. Dabei reicht es für die Montage des Gehäuses, dass die Gehäuseabdeckung 74 über daran angeformte Rastbügel 110 korrespondierende Rastnasen des Gehäuseelementes 70 übergreift. So sind beide Gehäuseelemente 70, 96 auf einfache Weise allein durch Verrasten miteinander gefügt.

Das gezeigte Ausführungsbeispiel hat drei jeweils einem SMD-Bauelement 4 zugeordnete Heizkreise I - III, denen im Leistungsteil zugeordnete wärmeerzeugende Lagen 86 zugeordnet sind. Dabei werden die Steuerungen für die Heizkreise II und III parallel aktiviert, so dass die entsprechenden Bereiche II und III des Leistungsteils gleichzeitig Wärme produzieren. Allerdings kann die Heizleistung der Heizkreise II und III durch die SMD-Bauelemente 4 variiert werden. Bei einer geringen Heizleistung wird lediglich der Heizkreis I eingeschaltet und gesteuert. Ist eine etwas höhere Heizleistung gefordert, wird der Heizkreis I abgeschaltet und die Heizkreise II und III eingeschaltet und gesteuert. Das Schalten und Steuern erfolgt jeweils allein durch das Ansteuern der MOSFET's. Bei maximaler Heizleistung sind sämtliche Heizkreise I bis III aktiv.

### Bezugszeichenliste

- 2: bestückte Metallplatteneinheit
- 4: SMD-Bauelement
- 6: Steckergehäuse
- 8: Metallplatte
- 10: elektrische Kontaktbrücke
- 12: elektrische Kontaktbrücke
- 14: Steg
- 16: Zuleitungsstromschiene
- 18: Anschlusszapfen
- 20: Zuleitungselement
- 22: SMD-Haltebasis
- 24: Steuerstromzuleitungselement
- 26: Ableitungselement
- 28: Steuerstromzuleitungselement
- 30: Steuerstromzuleitungselement
- 32: Schlitz
- 34: Kontaktfuß
- 36: Halteöffnung
- 38: Befestigungszapfen
- 40: Anschlussfahne
- 42: Gehäuse
- 44: Kfz-Zuheizer
- 48: Trägerelement
- 50: Rastnase
- 52: Gleitfläche
- 54: Bohrung
- 56: Zapfen
- 58: Kühlfahne
- 60: Kühlfensteröffnung
- 62: Stanzöffnung
- 64: Basis
- 66: Abstandssteg
- 68: Trennsteg
- 70: Gehäuseelement
- 72: Leistungsteil
- 74: Steuerteil
- 76: Stromschiene anderer Polarität
- 77: Stromschienensegment
- 78: Anschlussfahne anderer Polarität
- 79: Stromschienenstrang
- 80: Anschlusszapfen
- 82: Stützsteg
- 84: Wellrippenelement
- 86: wärmeerzeugende Lage
- 88: Heizblock
- 90: Federelement
- 91: PTC-Elemente
- 92: Kontaktblech
- 93: Positionsrahmen
- 94: Trennwand
- 95: Verbindungsfahne
- 96: Gehäuseabdeckung
- 98: Flansch
- 100: Kühlfenster
- 101: Steg
- 102: Verbindungsöffnung
- 104: erster Steg
- 106: zweiter Steg
- 108: dritter Steg
- 110: Rastbügel

## Patentansprüche

1. Steuervorrichtung für die Steuerung des Leistungsstromes einer elektrischen Heizvorrichtung eines Kraftfahrzeugs mit einem Trägerelement (48) und einer daran befestigten, den Leistungsstrom leitenden Stromschiene (20), die elektrisch leitend mit einem den Leistungsstrom steuernden SMD-Bauelement (4) verbunden ist,
**dadurch gekennzeichnet,**
**dass** die Stromschiene Teil einer zunächst einteiligen stanzbearbeiteten Metallplatte mit zumindest einem durchtrennten Steg ist, der die Metallplatte (8) in ein Zuleitungselement (20) als Stromschiene und ein Ableitungselement (26) als Stromschiene teilt, die lediglich über das SMD-Bauelement (4) elektrisch leitend miteinander verbunden sind.

2. Steuervorrichtung nach Anspruch 1, **dadurch gekennzeichnet, dass** das SMD-Bauelement (4) unmittelbar elektrisch mit dem Zuleitungselement (20) gebondet ist und dass das Zuleitungselement (20) als Wärmesenke (58) ausgebildet ist.

3. Steuervorrichtung nach Anspruch **2, dadurch gekennzeichnet, dass** die Wärmesenke (58) derart dimensioniert ist, dass das SMD-Bauelement (4) bei langfristigem maximalen Stromdurchfluss und einer Anströmung der Wärmesenke mit Luft eine Temperatur von 150 °C nicht überschreitet.

4. Steuervorrichtung nach einem der vorherigen Ansprüche, **dadurch gekennzeichnet, dass** das Zuleitungselement (20) zumindest teilweise in einer an dem Trägerelement (48) ausgebildeten Fensteröffnung (60) freiliegt.

5. Steuervorrichtung nach einem der vorherigen Ansprüche, **dadurch gekennzeichnet, dass** das Trägerelement (48) auf Höhe des durchtrennten Steges (14) eine Stanzöffnung (62) aufweist.

6. Steuervorrichtung nach einem der vorherigen Ansprüche, **dadurch gekennzeichnet, dass** die zunächst einteilige stanzbearbeitete Metallplatte (8) ein mit einer Steuestromzuleitung (34) des SMD-Bauelementes (4) verbundenes Steuerstromzuleitungselement (24, 30) enthält, welches über einen weiteren durchtrennten Steg (14) von dem Zuleitungselement (20) und/oder dem Ableitungselement (26) beabstandet ist.

7. Steuervorrichtung nach Anspruch 6, **dadurch gekennzeichnet, dass** das Steuerstromzuleitungselement (24, 30) durch eine Stromschiene gebildet ist, die schmaler als das Ableitungselement (26) oder das Zuleitungselement (20) ist.

8. Steuervorrichtung nach einem der vorherigen Ansprüche, **dadurch gekennzeichnet, dass** das Zuleitungselement (20) stegförmig ausgebildet ist und eine seitliche austragende SMD-Haltebasis (22) ausbildet, dass das Ableitungselement (26) auf Höhe des SMD-Bauelementes (4) endet und einen die austragende SMD-Haltebasis (22) aufnehmenden Einschnitt (45) aufweist und dass das Steuerzuleitungselement (24) auf Höhe des SMD-Bauelementes (4) endet und sich in Verlängerung des Ableitungs-elementes (26) erstreckt.

9. Steuervorrichtung nach einem der vorherigen Ansprüche, **dadurch gekennzeichnet, dass** das Trägerelement (48) Bondings von dem SMD-Bauelement (4) zu dem Ableitungselement (26) und/oder dem Zuleitungselement (20) und/oder dem Steuerstromzuleitungselement (24, 30) vollständig abdeckt.

10. Steuervorrichtung nach einem der vorherigen Ansprüche, **dadurch gekennzeichnet, dass** auf dem Trägerelement (48) zumindest zwei, vorzugsweise drei, Unterbaugruppen (I, II, III) aus jeweils einem Zuleitungselement (20), einem Ableitungselement (26) und einem SMD-Bauelement (4) angeordnet sind, wobei die das Zuleitungselement (20) und das Ableitungselement (26) einer Unterbaugruppe jeweils elektrisch miteinander verbindenden SMD-Bauelemente (4) nebeneinander angeordnet sind und die Zuleitungselemente (20) sämtlicher Unterbaugruppen (I, II, III) elektrisch miteinander über eine Zuleitungsstromschiene (16) verbunden sind.

11. Steuervorrichtung nach einem der vorherigen Ansprüche, **dadurch gekennzeichnet, dass** das Ableitungselement (26) mit seinem freien Ende das Zuleitungselement (20) überragt und eine Anschlussfahne (40) zum Anschluss an einen Leistungsteil (72) der elektrischen Heizvorrichtung (44) ausbildet.

12. Steuervorrichtung nach einem der vorherigen Ansprüche, **dadurch gekennzeichnet** durch eine weitere Stromschiene (76), die benachbart zu einer durch das Ableitungselement (26) gebildeten Anschlussfahne (40) eine Anschlussfahne (78) anderer Polarität ausbildet.

13. Bestückte Metallplatte einer den Leistungsstrom einer elektrischen Heizvorrichtung eines kraftfahrzeugs steuernden Steuervorrichtung mit den Leistungsstrom leitenden Leiterbahnen als Stromschienen wobei die bestückte Metallplatte eine einteilige stanzbearbeitete Metallplatte (8), die einen Zuleitungselementbereich (20B) als Stromschiene und einen Ableitungselementbereich (26B) als Stromschiene und zumindest einen die beiden Bereiche (20B; 26B) miteinander verbindenden Steg (14) ausbildet umfasst, wobei die metallplatte (8) mit einem den Leistungsstrom steuernden SMD-Bauelement (4) bestückt ist, das elektrisch leitend mit dem Zuleitungselementbereich (20B) und dem Ableitungselementbereich (26B) verbunden ist und einen mit einem weiteren Steg (14) angebundenen und mit einem Steckergehäuse (6) versehenen Steuerstromelementbereich (30) umfasst, der elektrisch mit dem SMD-Bauelement (4) verbunden ist.

14. Elektrische Heizvorrichtung für ein Kraftfahrzeug mit einem Leistungsteil
(72), umfassend zumindest eine wärmeerzeugende Lage (86) mit wenigstens einem PTC-Element und beidseitig daran anliegenden Kontaktblechen (92), eine wärmeabgebende Lage (84) und ein Steuerteil (74), welches in baulicher Einheit mit dem Leistungsteil (72) vorgesehen ist,
**dadurch gekennzeichnet,**
**dass** das Steuerteil (74) eine Steuervorrichtung nach einem der Ansprüche 1 bis 12 umfasst und dass eines der Kontaktbleche (92) elektrisch leitend mit dem Ableitungselement (26) verbunden ist.

15. Elektrische Heizvorrichtung nach Anspruch 14, soweit von Anspruch 12 abhängig, **dadurch gekennzeichnet, dass** ein anderes Kontaktblech (92) elektrisch leitend mit der durch die weitere Stromschiene (76) ausgebildeten Anschlussfahne (78) anderer Polarität verbunden ist.

16. Elektrische Heizvorrichtung nach Anspruch 15, **gekennzeichnet durch** ein schalenförmiges Gehäuseelement (70), welches den Leistungsteil (72) und den Steuerteil (74) aufnimmt und ein Gehäusegegenelement (96), welches unter Einschluss von Leistungs- und Steuerteil (72, 74) das schalenförmige Gehäuseelement (70) abdeckt, wobei zumindest eines von Gehäuseelement (70) und Gehäusegegenelement (96) im Bereich der Anschlussfahnen (40, 78) zumindest eine Verbindungsöffnung (102) zum Herstellen einer mechanischen Verbindung zwischen der Anschlussfahne (40, 78) des Steuerteils (74) und einer dagegen anliegenden Verbindungsfahne (95) des Leistungsteils (72) ausbildet.

17. Verfahren zur Herstellung einer elektrischen Heizvorrichtung eines Kraftfahrzeugs mit den Schritten:
a) Herstellen einer stanzbearbeiteten Metallplatte (8), die zumindest einen Zuleitungselementbereich (20B) und einen Ableitungselementbereich (26B) als zwei den Leistungsstrom Leitenden Stromschienen bildet, welche über zumindest einen Steg (14) miteinander verbunden sind,
b) Montieren eines den Leistungsstrom steuernden SMD-Bauelementes (4) auf dem Zuleitungselementbereich (20B) zur Bildung einer bestückten Metallplatteneinheit (2),
c) Befestigen der bestückten Metallplatteneinheit (2) an einem zuvor hergestellten Trägerelement (48),
d) Durchtrennen des zumindest einen Steges (14), so dass aus dem Zuleitungselementbereich (20B) und dem Ableitungselementbereich (26B) ein Zuleitungselement (20) bzw. ein Ableitungselement (26) erzeugt wird, die lediglich über das SMD-Bauelement (4) elektrisch leitend miteinander verbunden sind.

18. Verfahren nach Anspruch 17, **dadurch gekennzeichnet, dass** die Schritte c) und d) im Wesentlichen zeitgleich durchgeführt werden.

## Claims

1. Control device for controlling the power current of an electric heating device of an automotive vehicle with a support element (48) and a busbar (20) which is fastened thereto and conducts the power current and is connected in an electrically conductive manner to an SMD component (4) which controls the power current,
**characterized in**
**that** the busbar is part of an initially single-part punch-processed metal plate with at least one severed web which divides the metal plate (8) into a supply element (10) as busbar and into a discharge element (26) as busbar, said elements being electrically conductively interconnected just via the SMD component (4).

2. Control device according to claim 1, **characterized in that** the SMD component (4) is directly electrically bonded to the supply element (20) and that the supply element (20) is designed as a heat sink (58).

3. Control device according to claim 2, **characterized in that** the heat sink (58) is dimensioned such that the SMD component (4) in case of a long-term maximal current flow and with air flowing against the heat sink does not exceed a temperature of 150°C.

4. Control device according to any one of the preceding claims, **characterized in that** the supply element (20) is exposed at least in part in a window opening (60) formed on the support element (48).

5. Control device according to any one of the preceding claims, **characterized in that** the support element (48) comprises a punch opening (82) at the level of the severed web (9).

6. Control device according to any one of the preceding claims, **characterized in that** the initially one-part punch-processed metal plate (8) includes a control current supply element (24, 30) which is connected to a control current supply (34) of the SMD component (4) and which is spaced apart from the supply element (20) and/or the discharge element (26) via a further severed web (14).

7. Control device according to claim 6, **characterized in that** the control current supply element (24, 30) is formed by a busbar which is smaller than the discharge element (26) or the supply element (20).

8. Control device according to any one of the preceding claims, **characterized in that** the supply element (20) is web-shaped and forms a laterally protruding SMD holding base (22), that the discharge element (26) ends at the level of the SMD component (4) and comprises an incision (45) receiving the protruding SMD holding base (22) and that the control supply element (24) ends at the level of the SMD component (4) and extends in extension of the discharge element (26).

9. Control device according to any one of the preceding claims, **characterized in that** the support element (48) fully covers bondings from the SMD component (4) to the discharge element (26) and/or the supply element (20) and/or the control current supply element (24, 30).

10. Control device according to any one of the preceding claims, **characterized in that** at least two, preferably three, subassemblies (I, II, III), each consisting of a supply element (20), a discharge element (26) and an SMD component (4), are disposed on the support element (48), wherein the SMD components (4) respectively electrically interconnecting the supply element (20) and the discharge element (26) of a subassembly are arranged side by side, and the supply elements (20) of all subassemblies (I, II, III) are electrically interconnected via a supply busbar (16).

11. Control device according to any one of the preceding claims, **characterized in that** the discharge element (26) projects with its free end over the supply element (20) and forms a connecting lug (40) for connection to a power part (72) of the electric heating device (44).

12. Control device according to any one of the preceding claims, **characterized by** a further busbar (76) which next to a connecting lug (40) formed by the discharge element (26) forms a connecting lug (78) of different polarity.

13. Equipped metal plate of a control device controlling the power current of an electric heating device of an automotive vehicle with conductor paths conducting the power current as busbars, wherein the equipped metal plate comprises a one-part punch-processed metal plate (8) which forms a supply element region (20B) as busbar and a discharge element region (26B) as busbar and at least one web (14) interconnecting the two regions (20B;
26B), wherein the metal plate (8) is equipped with an SMD component (4) which controls the power current and which is connected in an electrically conductive manner to the supply element region (20B) and to the discharge element region (26B) and comprises a control current element region (30) which is attached with a further web (14) and provided with a connector housing (6) and which is electrically connected to the SMD component (4).

14. Electric heating device for an automotive vehicle with a power part (72), comprising at least one heat-generating layer (86) with at least one PTC element and contact sheets (92) adjacent thereto at both sides, a heat-discharging layer (84) and a control part (74) which is provided in constructional unit with the power part (72),
**characterized in**
**that** the control part (74) comprises a control device according to any one of claims 1 to 12 and that one of the contact sheets (92) is connected in an electrically conductive manner to the discharge element (26).

15. Electric heating device according to claim 14, as far as depending on claim 12, **characterized in that** another contact sheet (92) is connected in an electrically conductive manner to the connecting lug (78) of different polarity which is formed by the further busbar (76).

16. Electric heating device according to claim 15, **characterized by** a shell-shaped housing element (70) which accommodates the power part (72) and the control part (74), and a housing counterpart (96) which with inclusion of power part and control part (72, 74) covers the shell-shaped housing element (70), wherein at least one of housing element (70) and housing counterpart (96) in the area of the connecting lugs (40, 79) forms at least one connection opening (102) for establishing a mechanical connection between the connecting lug (40, 78) of the control part (74) and a connection lug (95) of the power part (72) abutting thereon.

17. Method for producing an electric connecting device of an automotive vehicle, comprising the steps:
a) producing a punch-processed metal plate (8) which forms at least one supply element region (20B) and one discharge element region (26B) as two busbars conducting the power current, said regions being interconnected via at least one web (14),
b) mounting an SMD component (4) controlling the power current on the supply element region (20B) for forming an equipped metal plate unit (2),
c) fastening the equipped metal plate unit (2) to a previously produced support element (48),
d) severing the at least one web (14), so that a supply element (20) and a discharge element (26), respectively, are produced from the supply element region (20B) and the discharge element region (26B), said elements being interconnected in an electrically conductive manner only via the SMD component (4).

18. Method according to claim 17, **characterized in that** steps c) and d) are carried out substantially at the same time.

## Revendications

1. Dispositif de commande destiné à assurer la commande du courant de puissance d'un dispositif de chauffage électrique d'un véhicule automobile, comprenant un élément de support (48) sur lequel est fixée une barre de distribution de courant (20), qui conduit le courant de puissance et est reliée de manière électriquement conductrice à un composant SMD (4) (composant monté en surface) commandant le courant de puissance,
**caractérisé en ce que** la barre de distribution de courant est une partie d'une plaque de métal tout d'abord d'un seul tenant et usinée par découpage-matriçage, comprenant au moins une branche de sectionnement, qui subdivise la plaque de métal (8) en un élément conducteur d'entrée (20) sous forme de barre de distribution de courant, et un élément conducteur de sortie (26) sous forme de barre de distribution de courant, qui ne sont reliés électriquement que par l'intermédiaire du composant SMD (4).

2. Dispositif de commande selon la revendication 1, **caractérisé en ce que** le composant SMD (4) est relié par soudage, directement, de manière électrique, à l'élément conducteur d'entrée (20), et **en ce que** l'élément conducteur d'entrée (20) est réalisé en tant que dissipateur thermique (58).

3. Dispositif de commande selon la revendication 2, **caractérisé en ce que** le dissipateur thermique (58) est dimensionné de manière telle, que le composant SMD (4), dans le cas d'une circulation de courant maximal de longue durée et d'un balayage du dissipateur thermique par de l'air, ne dépasse pas une température de 150°C.

4. Dispositif de commande selon l'une des revendications précédentes, **caractérisé en ce que** l'élément conducteur d'entrée (20) est au moins partiellement dégagé dans une ouverture de fenêtre (60) formée dans l'élément de support (48).

5. Dispositif de commande selon l'une des revendications précédentes, **caractérisé en ce que** l'élément de support (48) présente, au niveau de la branche de sectionnement (14), une ouverture découpée (62).

6. Dispositif de commande selon l'une des revendications précédentes, **caractérisé en ce que** la plaque de métal (8) usinée par découpage-matriçage, tout d'abord d'un seul tenant, comporte un élément d'alimentation en courant de commande (24, 30), qui est relié à une entrée de courant de commande (34) du composant SMD (4), et qui est espacé par l'intermédiaire d'une autre branche de sectionnement (14) de l'élément conducteur d'entrée (20) et/ou de l'élément conducteur de sortie (26).

7. Dispositif de commande selon la revendication 6, **caractérisé en ce que** l'élément d'alimentation en courant de commande (24, 30) est formée par une barre de distribution de courant, qui est plus étroite que l'élément conducteur de sortie (26) ou l'élément conducteur d'entrée (20).

8. Dispositif de commande selon l'une des revendications précédentes, **caractérisé en ce que** l'élément conducteur d'entrée (20) est réalisé sous forme de patte et forme une base de support de SMD (22) en porte-à-faux latéral, **en ce que** l'élément conducteur de sortie (26) se termine à hauteur du composant SMD (4) et présente une encoche (45) recevant la base de support de SMD (22) en porte-à-faux, et **en ce que** l'élément d'alimentation en courant de commande (24) se termine à hauteur du composant SMD (4) et s'étend en prolongement de l'élément conducteur de sortie (26).

9. Dispositif de commande selon l'une des revendications précédentes, **caractérisé en ce que** l'élément de support (48) recouvre complètement les zones de liaison soudée du composant SMD (4) à l'élément conducteur de sortie (26) et/ou à l'élément conducteur d'entrée (20) et/ou à l'élément d'alimentation en courant de commande (24, 30).

10. Dispositif de commande selon l'une des revendications précédentes, **caractérisé en ce que** sur l'élément de support (48) sont agencés au moins deux, de préférence trois sous-groupes (I, II, III) composés chacun d'un élément conducteur d'entrée (20), d'un élément conducteur de sortie (26) et d'un composant SMD (4), les composants SMD (4), qui relient électriquement respectivement l'élément conducteur d'entrée (20) et l'élément conducteur de sortie (26) d'un sous-groupe, étant disposés côte à côte, et les éléments conducteurs d'entrée (20) de tous les sous-groupes (I, II, III) étant reliés électriquement, ensemble, par l'intermédiaire d'une barre de distribution de courant d'entrée (16).

11. Dispositif de commande selon l'une des revendications précédentes, **caractérisé en ce que** l'élément conducteur de sortie (26) dépasse, avec son extrémité libre, de l'élément conducteur d'entrée (20), et forme une fiche de raccordement (40) destinée au raccordement à une partie de puissance (72) du dispositif de chauffage électrique (44).

12. Dispositif de commande selon l'une des revendications précédentes, **caractérisé par** une barre de distribution de courant supplémentaire (76), qui forme, au voisinage d'une fiche de raccordement (40) formée par l'élément conducteur de sortie (26), une fiche de raccordement (78) d'une autre polarité.

13. Plaque de métal équipée, d'un dispositif de commande qui assure la commande du courant de puissance d'un dispositif de chauffage électrique d'un véhicule automobile, comprenant des pistes conductrices sous forme de barres de distribution de courant, qui conduisent le courant de puissance, ensemble dans lequel la plaque de métal équipée comprend une plaque de métal (8) d'un seul tenant et usinée par découpage-matriçage, qui forme une zone d'élément conducteur d'entrée (20B) sous forme de barre de distribution de courant, et une zone d'élément conducteur de sortie (26B) sous forme de barre de distribution de courant, et au moins une branche (14) reliant l'une à l'autre les deux zones (20B, 26B), et dans lequel la plaque de métal (8) est équipée d'un composant SMD (4), qui commande le courant de puissance et est relié électriquement à la zone d'élément conducteur d'entrée (20B) et à la zone d'élément conducteur de sortie (26B), et comporte une zone d'élément de courant de commande (30), qui y est rattachée par une autre branche (14) et est pourvue d'un boitier de connecteur (6) et qui est reliée électriquement au composant SMD (4).

14. Dispositif de chauffage électrique pour un véhicule automobile, avec une partie de puissance (72), comprenant au moins une couche (68) de production de chaleur avec au moins un élément PTC (à coefficient de température positif) et des tôles de contact (92) qui s'y appuient de part et d'autre, une couche de diffusion de la chaleur (84), et une partie de commande (74), qui est prévue sous forme d'unité de construction avec la partie de puissance (72),
**caractérisé**
**en ce que** la partie de commande (74) comporte un dispositif de commande selon l'une des revendications 1 à 12, et en ce que l'une des tôles de contact (92) est reliée de manière électriquement conductrice à l'élément conducteur de sortie (26).

15. Dispositif de chauffage électrique selon la revendication 14, dans la mesure où elle est rattachée à la revendication 12, **caractérisé en ce qu'**une autre tôle de contact (92) est reliée de manière électriquement conductrice à la fiche de raccordement (78) d'une autre polarité, formée par ladite autre barre de distribution de courant (76).

16. Dispositif de chauffage électrique selon la revendication 15, **caractérisé par** un élément de boitier (70) en forme de coque, qui accueille la partie de puissance (72) et la partie de commande (74), et par un élément de boitier conjugué (96), qui recouvre l'élément de boitier (70) en forme de coque en y incluant la partie de puissance et la partie de commande (72, 74), au moins l'un parmi l'élément de boitier (70) et l'élément de boitier conjugué (96) formant dans la zone des fiches de raccordement (40, 78), au moins une ouverture de liaison (102) pour établir une liaison mécanique entre la fiche de raccordement (40, 78) de la partie de commande (74) et une fiche de liaison (95) de la partie de puissance (72), qui vient s'y appuyer.

17. Procédé de fabrication d'un dispositif de chauffage électrique d'un véhicule automobile, comprenant les étapes suivantes :
a) fabrication d'une plaque de métal (8) usinée par découpage-matriçage, qui forme au moins une zone d'élément conducteur d'entrée (20B) et une zone d'élément conducteur de sortie (26B) sous forme de deux barres de distribution de courant conduisant le courant de puissance, qui sont reliées l'une à l'autre par au moins une branche (14),
b) montage d'un composant SMD (4) commandant le courant de puissance, sur la zone d'élément conducteur d'entrée (20B) pour former une unité de plaque de métal équipée (2),
c) fixation de l'unité de plaque de métal équipée (2) sur un élément de support (48) fabriqué auparavant,
d) sectionnement de ladite au moins une branche (14), de manière à produire, à partir de la zone d'élément conducteur d'entrée (20B) et de la zone d'élément conducteur de sortie (26B), un élément conducteur d'entrée (20) et un élément conducteur de sortie (26), qui ne sont reliés électriquement que par l'intermédiaire du composant SMD (4).

18. Procédé selon la revendication 17, **caractérisé en ce que** les étapes c) et d) sont exécutées sensiblement en même temps.
